Europäisches Patentamt

European Patent Office

Office européen des brevets

(11) Veröffentlichungsnummer: **0 425 866 A2**

# EUROPÄISCHE PATENTANMELDUNG

(21) Anmeldenummer: 90119584.2

(22) Anmeldetag: 12.10.90

(51) Int. Cl.5: **H05K 3/30**, H05K 3/34, B05D 1/26, B05C 5/00

(30) Priorität: 26.10.89 DE 3935709

(43) Veröffentlichungstag der Anmeldung: 08.05.91 Patentblatt 91/19

(84) Benannte Vertragsstaaten: CH DE FR GB LI NL

(71) Anmelder: FIRMA ELECTRONAL GESELLSCHAFT FÜR ELEKTRONIKWERKSTOFFE mbH Maternusstrasse 46 W-5000 Köln 50(DE)

(72) Erfinder: Sturm, Karsten Uferstrasse 19 W-5000 Köln 50(DE)

(74) Vertreter: Bauer, Wulf, Dr. Wolfgang-Müller-Strasse 12 W-5000 Köln 51(DE)

(54) **Verfahren und Vorrichtung zum Aufbringen kleiner Mengen einer pastösen Masse auf Leiterplatten.**

(57) Bei dem Verfahren und der Vorrichtung zum Aufbringen kleiner Mengen einer pastösen Masse (22), z. B. Kleber oder Lötpaste, auf Leiterplatten wird die pastöse Masse aus einem gekühlten Vorratsbehälter (20) unter mechanischem oder hydraulischem Druck über eine erste, gekühlte Leitung (28) zu einer Zwischenstation gefördert. In der Zwischenstation wird die pastöse Masse einerseits aufgewärmt und andererseits druckmäßig so entspannt, daß am Dispenserkopf (36) der gewünschte Arbeitsdruck herrscht. Die Zwischenstation ist über eine zweite Leitung (38) mit dem Dispenserkopf verbunden, mindestens eine der beiden Leitungen (28 oder 38) ist flexibel ausgeführt.

EP 0 425 866 A2

# VERFAHREN UND VORRICHTUNG ZUM AUFBRINGEN KLEINER MENGEN EINER PASTÖSEN MASSE AUF LEITERPLATTEN

Die Erfindung bezieht sich auf ein Verfahren und eine Vorrichtung zum Aufbringen kleiner Mengen einer pastösen Masse, z. B. Kleber oder Lötpaste, auf Leiterplatten, bei dem verfahrensmäßig die Masse aus einem Vorratsbehälter unter Druck über eine Leitung einem Dispenserkopf zugeführt und von diesem bei Verarbeitungsdruck und -temperatur portionsweise auf die Leiterplatte ausgegeben wird.

Elektronische Bauteile, wie beispielsweise Kondensatoren, Widerstände, Transistoren, integrierte Schaltungen usw. werden beim SMD-Verfahren (Oberflächenmontage) zunächst auf die Leiterplatte aufgeklebt und anschließend mit Leiterbahnen der Leiterplatte verlötet. Dispensereinrichtungen ermöglichen eine bauteilgerechte Mengendosierung und aufgrund einer üblicherweise vorhandenen Rechnersteuerung eine exakte lokale Positionierung der pastös-flüssigen Massen. Dabei wird portionsweise auf vorbestimmte Punkte der Leiterplatte jeweils eine kleine Menge der pastösen Masse aufgetragen. Die Abkürzung SMD steht für "surface mounted device".

Bei dem bekannten Verfahren bzw. der nach diesem Verfahren arbeitenden Vorrichtung befindet sich der Vorratsbehälter oberhalb des Dispenserkopfes, er ist auswechselbar und als kleine, rohrförmige Kartusche ausgeführt. Diese wird von oben durch Druckluft beaufschlagt, so daß sie unter Druck steht und über die Leitung zum Dispenserkopf strömen kann.

Beim Betrieb wird der Dispenserkopf rechnergesteuert über bestimmten Punkten der noch unbestückten oder bereits teilweise bestückten Leiterplatine bewegt und abgesenkt, sowie wieder angehoben. Die mit ihm verbundene Kartusche macht diese Bewegungen mit. In der Kartusche befindet sich üblicherweise der für einen kompletten Arbeitslauf oder für eine gesamte Schicht benötigte Vorrat an Kleber oder Lötpaste. Dabei muder Inhalt der Kartusche so bemessen sein, daß in Abhängigkeit von der während eines vorbestimmten Arbeitslaufes benötigten Menge ausreichend Klebstoff bzw. Lötpaste vorhanden ist, damit auf keinen Fall während der Bearbeitung einer Leiterplatine bzw. eines Satzes Leiterplatinen der Vorrat zu Ende geht. Um Ausschuß zu vermeiden, ist es daher bereits in der DE-OS 38 42 166 vorgeschlagen worden, einerseits in der Kartusche eine Füllstandsanzeige vorzusehen und andererseits die Kartusche in einem Halter anzuordnen, der Platz für zumindest zwei unterschiedliche Kartuschengrößen bietet, so daß in Abstimmung mit der voraussichtlich benötigten Menge an Kleber bzw. Lötpaste eine kleinere bzw. größere Kartusche eingesetzt werden kann.

Nachteilig und insbesondere bei dem Bestreben, das Auftragen zu beschleunigen hinderlich ist die zudem noch nach Füllstand unterschiedliche schwere Masse der Kartusche, die sich zur Masse des Dispenserkopfes addiert. Für die Bewegungen sind daher höhere Kräfte und entsprechend solide ausgelegte Antriebsvorrichtungen notwendig.

Nachteilig ist aber auch, daß nach einem Arbeitslauf bzw. einer Schicht die Kartusche, unabhängig von ihrem jeweiligen Füllstand - ausgetauscht werden muß, wenn man vermeiden will, daß beim nachfolgenden Arbeitsgang Ausschuß auftritt, weil die Kartusche plötzlich leer wurde. Hier hilft zwar eine Füllstandsanzeige, sie kann aber auch nicht verhindern, daß während eines Arbeitslaufs die Dispensereinrichtung aufgrund leerer Kartusche stoppt, worauf eine neue Kartusche eingesetzt und die entsprechenden Justierungen durchgeführt werden müssen, bevor wieder weitergearbeitet werden kann. Da eine Füllstandsanzeige schon dann ansprechen muß, wenn noch soviel an Kleber bzw. Lötpaste in der Kartusche ist, wie für das Auftragen auf eine gerade begonnene Leiterplatte bzw. einen Satz Leiterplatten benötigt wird, wird auf jeden Fall Kleber bzw. Lötpaste vergeudet. Entscheidender aber sind die Stillstände während des Arbeitsablaufes, sie machen sich störend in der Produktionszeit bemerkbar. Es besteht daher ein Bedürfnis nach relativ großen Vorratsbehältern, vorzugsweise einer kontinuierlichen Zuführung der aufzutragenden Masse. Hier steht aber entge gen, daß größerem Volumen des Vorratsbehälters dessen schwere Masse auch - zumindest bei anfänglichem Füllstand - hoch ist, so daß ein noch größeres Gewicht zu transportieren ist. Zudem hat man oberhalb oder seitlich des Dispenserkopfes nicht ausreichend Platz für einen größeren Vorratsbehälter. Andererseits muß aber auch vermieden werden, daß die pastöse Masse im Vorratsbehälter altert, beispielsweise daß der Kleber abbindet. Dies kann im allgemeinen nur durch eine Kühlung des Vorratsbehälters vermieden werden, eine zusätzliche Kühleinrichtung würde auch noch zum Gewicht beitragen. Schließlich läßt sich gekühlter Kleber bzw. gekühlte Lötpaste nicht mehr bei ungefährlichen Luftdrucken fördern, vielsmehr müssen Drükke aufgebracht werden, die eine Kapselung bzw. Panzerung aus Sicherheitsgründen erfordern. Hierdurch wird wiederum Gewicht hinzugefügt.

Ausgehend von dem Verfahren bzw. der Vorrichtung der eingangs genannten Art hat sich die Erfindung die Aufgabe gestellt, ein Verfahren und eine nach diesem Verfahren arbeitende Vorrichtung zum weitestgehend kontinuierlichen Aufbringen kleiner Mengen der pastösen Masse anzugeben, bei dem ein so ausreichend großer Vorratsbehälter eingesetzt wird, daß die Austauschzyklen deutlich verlängert werden und der Vorratsbehälter nicht mitbewegt werden muß.

Verfahrensmäßig wird diese Aufgabe ausgehend vom bekannten Verfahren der eingangs genannten Art dadurch gelöst, daß die pastöse Masse bei niedriger, deutlich unter der Verarbeitungstemperatur liegender Temperatur und einem hohen, deutlich über dem Verarbeitungsdruck liegenden Druck mittels einer mechanischen Pumpe, insbesondere Schneckenpumpe, aus dem gekühlten, ortsfest angeordneten Vorratsbehälter über eine erste, gekühlte Leitung zu einer Zwischenstation gefördert wird, daß in der Zwischenstation die Masse einerseits aufgewärmt und dabei so temperiert wird, daß am Dispenserkopf die gewünschte Verarbeitungstemperatur vorliegt und andererseits druckmäßig so entspannt wird, daß am Dispenserkopf der gewünschte Arbeitsdruck herrscht, daß die Zwischenstation über eine zweite Leitung mit dem Dispenserkopf verbunden ist und mindestens eine der beiden Leitungen flexibel ausgeführt ist, und daß über einen im Bereich des Dispenserkopfes angeordneten, kleinen Druckpuffer ein Druckabfall des hydrostatischen Drucks der pastösen Masse während jeder Ausgabe einer kleinen Menge abgepuffert wird.

Vorrichtungsmäßig wird diese Aufgabe dadurch gelöst, daß eine mechanische Pumpe, ins eine Schneckenpumpe vorgesehen ist, die die Masse aus dem gekühlten, ortsfest angeordneten Vorratsbehälter und mit einem Druck oberhalb 10 bar fördert und die über eine erste, gekühlte Leitung mit einer Zwischenstation verbunden ist, daß diese Zwischenstation eine Druckregel- und Temperiereinrichtung aufweist und über eine zweite Leitung an den Dispenserkopf angeschlossen ist, wobei mindestens eine Leitung flexibel ausgebildet ist, daß die Druckregeleinrichtung den Druck der pastösen Masse soweit herabsetzt, daß am Dispenserkopf der Verarbeitungsdruck anliegt und daß die Temperiereinrichtung die Temperatur der Masse soweit erhöht, daß am Dispenserkopf die notwendige Verarbeitungstemperatur der Masse vorliegt und daß im Bereich des Dispenserkopfes ein kleiner Druckspeicher angeordnet ist, der einen Druckabfall der Masse während der Ausgabe einer kleinen Menge auf die Leiterplatte abpuffert.

Erfindungsgemäß ist somit der Vorratsbehälter separat vom Dispenserkopf angeordnet und insbesondere mit diesem nicht mehr bewegungsverbunden. Der Vorratsbehälter ist so gekühlt, daß die in ihm befindliche pastöse Masse über einen längeren Zeitraum, insbesondere mehrere Wochen oder Monate, ohne Alterungserscheinungen aufbewahrt werden kann. Erfindungsgemäß kann der Vorratsbehälter einerseits relativ groß gewählt werden, beispielsweise ein Fassungsvermögen von einem Liter aufweisen, andererseits an einem beliebigen Ort und insbesondere an einer Position, bei der ein Schnellaustausch einfach und bequem durchzuführen ist, untergebracht werden. Hierdurch werden die Austauschzyklen vergrößert, es entfällt eine Neujustierung nach einem Austausch, es kann praktisch kontinuierlich geabeitet werden. Erfolgt vorteilhafterweise eine Anzeige, wenn der Vorratsbehälter leer ist und wird dann unmittelbar ein neuer, gefüllter Vorratsbehälter eingesetzt, muß ein Arbeitsablauf der Gesamtvorrichtung nicht einmal unterbrochen werden, es ist also eine vollständig kontinuierliche Arbeitsweise möglich.

Die Zwischenstation ist vorteilhafterweise in Nähe des Dispenserkopfes angeordnet, sie kann auch mit diesem verbunden sein. Vorteilhafterweise ist sie jedoch über eine flexibel ausgebildete zweite Leitung mit dem Dispenserkopf verbunden. Die flexible Leitung stellt sicher, daß die Zwischenstation ortsfest angeordnet werden kann und die Bewegungen des Dispenserkopfes aufgenommen werden. Da erst in der Zwischenstation die Temperierung der pastösen Masse erfolgt und die erste, zur Zwischenstation führende Leitung gekühlt ist, können Alterungsprozesse erst hinter der Zwischenstation auftreten. Wird das Innenvolumen der zweiten Leitung und des Dispenserkopfes ausreichend kleiner gewählt, so ist die Menge an pastöser Masse, deren Temperatur im Bereich der Verarbeitungstemperatur liegt, gering, jedenfalls geringer als bei der Vorrichtung nach dem Stand der Technik, so daß für diese Menge an pastöser Masse Veränderungen durch Alterung noch weniger in Betracht kommt als bei der Vorrichtung nach dem Stand der Technik.

Als besonders vorteilhaft hat sich die Abkehr von einer pneumatischen Förderung erwiesen. Erfindungsgemäß wird die pastöse Masse ausschließlich durch eine mechanische Pumpe gefördert. Wegen der Inkompressibilität von Flüssigkeiten tritt auch bei einem Platzen oder bei Leckstellen keine Gefahr auf, weiterhin wird vermieden, daß sich Druckluft in irgendeiner Form mit der pastösen Masse vermengen kann. Einschlüsse von Luftblasen in der pastösen Masse würden zu Produktionsausfällen führen.

Insgesamt lassen sich erfindungsgemäß also aufwendige Sicherungseinrichtungen, insbesondere eine Panzerung, vermeiden.

Die Erfindung eröffnet schließlich den Vorteil, daß mit einem Vorratsbehälter, einer Pumpe und nur einer Zwischenstation mehrere Dispenservorrichtungen versorgt werden können. Hierzu ist vorteilhafterweise vorgesehen, daß an der Zwischenstation mindestens eine weitere, zweite Leitung angeschlossen werden kann. Sie ist mit einem Dispenserkopf einer zweiten Vorrichtung verbunden. Als sehr vorteilhaft hat es sich dabei erwiesen, wenn die Längen der beiden zweiten Leitungen gleichlang gewählt werden. Dann liegen an den Dispenserköpfen vergleichbare Zustände, insbesondere Verarbeitungstemperatur und -druck, vor.

Weitere Vorteile und Merkmale der Erfindung ergeben sich aus den übrigen Ansprüchen sowie der nun folgenden Beschreibung von nicht einschränkend zu verstehenden Ausführungsbeispielen, die unter Bezugnahme auf die Zeichnung näher erläutert werden. In dieser zeigen:

Fig. 1 eine vereinfachte teilweise schnittbildlich und als Blockdiagramm ausgeführte Darstellung zur prinzipiellen Erläuterung der Erfindung und

Fig. 2 ein Funktionsschaltbild einer erfindungsgemäßen Vorrichtung.

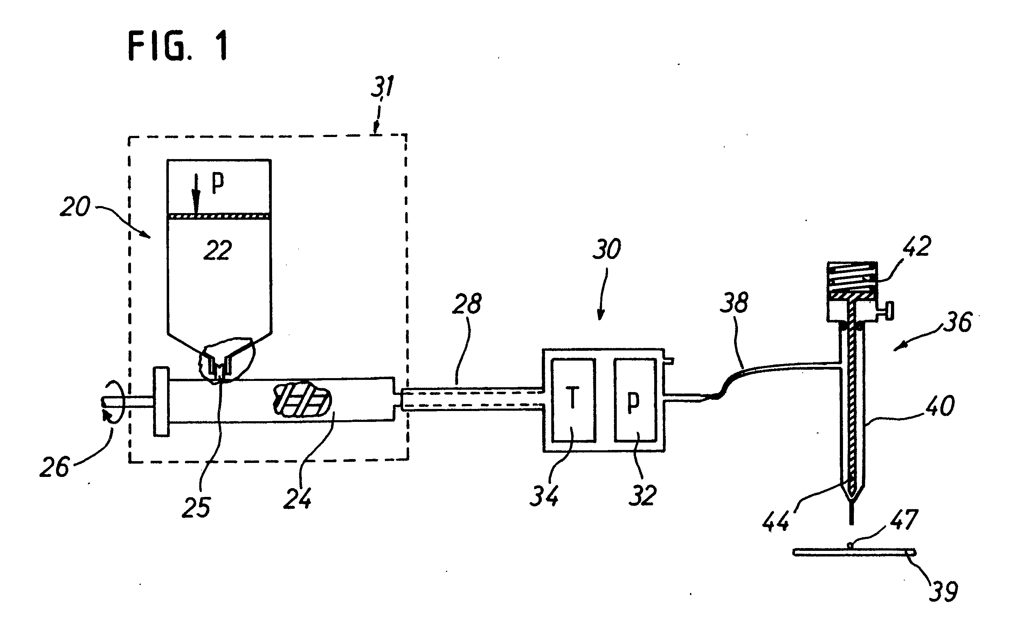

In Fig. 1 ist links ein Vorratsbehälter 20 mit einem Vorrat an pastöser Masse 22, im hier gezeigten Ausführungsbeispiel an Kleber, dargestellt, der auf eine Schneckenpumpe 24 oben aufgesetzt ist, hierzu springt vom Gehäuse dieser Pumpe 24 ein Ansatz 25 nach oben vor, in den ein unterer, zerstörbarer Bereich des ansonsten vollständig, unter Vakuum gefüllten, abgeschlossenen Vorratsbehälters 20 eingedrückt ist. Die Anordnung ist dabei so getroffen, daß stets bei Entnahme eines entleerten Vorratsbehälters 20 auf dem Ansatz 25 eine Restmenge an Kleber verbleibt, so daß beim Aufsetzen eines neuen, vollen Vorratsbehälters diese Restmenge teilweise zur Seite gepreßt wird, jedenfalls keine Luftblasen eingeschlossen werden.

Die Pumpe 24 wird durch einen nicht dargestellten Elektromotor im Sinne des Pfeiles 26 angetrieben. Am Ausgang ist die Pumpen 24 über eine hochdruckfeste erste Leitung 28 mit einer Zwischenstation 30 verbunden.

Wie aus Fig. 1 ersichtlich ist, befinden sich Vorratsbehälter 20 und Pumpe 24 innerhalb eines gekühlten Bereichs 31, ebenfalls ist die erste Leitung 28 gekühlt. Für das Beispiel Kleber als pastöse Masse beträgt die Temperatur dort 5 °C. Die Pumpe 24 ist so ausgelegt, daß ausgangsseitig ein Druck von 50 bar oder mehr, z. B. ca. 150 bar, vorliegt.

In der Zwischenstation 30 sind eine Druckregeleinrichtung 32 und eine Temperiereinrichtung 34 vorgesehen. In ersterer wird der statische Druck im Kleber herabgesetzt auf etwa 1,8 bis 5 bar, vorzugsweise 2 bis 3 bar, jedenfalls auf einen Druck, der für einen portionsweisen Ausstoß in einem noch zu beschreibende Dosierkopf 36 geeignet ist. Der tatsächliche Druck ist im wesentlichen durch die Auslegung des Dosierkopfes 36 bestimmt.

Weiterhin befindet sich in der Zwischenstation 30 eine Temperiereinrichtung 34, die vorzugsweise elektrisch beheizt ist. In ihr wird der einströmende, gekühlte Kleber auf eine Temperatur zwischen 23 und 28 °C erwärmt.

Ausgangsseitig ist die Zwischenstation 30 über eine flexible, zweite Leitung 38 an den Dispenserkopf 36 angeschlossen. Diese Leitung 38 hat einen möglichst geringen Innenquerschnitt und kann, wenn es nötig ist, isoliert oder temperiert sein, damit der in ihr befindliche Kleber die angegebene Temperatur beibehält.

Da die zweite Leitung 38 flexibel ausgebildet ist, kann der Dispenserkopf 36 bei ortsfester Montage der Zwischenstation 30 frei innerhalb des Arbeitsbereiches der erfindungsgemäßen Vorrichtung über eine Leiterplatte 39 verfahren werden.

Als sehr vorteilhaft hat es sich erwiesen, im Dispenserkopf 36 einen Druckmess- und einen Temperaturerfassungssensor anzuordnen und über diese, in Figur 1 gekennzeichnet durch gestrichelte Verbindungen, die elektronischen Regelkreise der Einrichtung 32 bzw. 34 zu steuern.

Der Dispenserkopf 36 ist im wesentlichen ein schnell öffnendes und schließendes Ventil. In einem Gehäuse 40, das im wesentlichen rohrförmig und schlank ausgeführt ist, befindet sich unten ein kegelförmiger Dichtsitz, gegen den belastet durch eine Feder 42 ein Ventilelement 44 in abdichtende Position gedrückt wird. Letzteres kann in Gegenrichtung zur Druckwirkung der Feder 42 mit Druckluft beaufschlagt werden, die über einen Anschluß 46 stoßweise zugeleitet wird. Bei einem Druckluftstoß wird das Ventilelement vom Ventilsitz und gegen die Kraft der Feder 42 kurzzeitig abgehoben, dadurch wird an einem Auslaß 48 des Dispenserkopfes 36 eine geringe Menge an Kleber ausgegeben.

Der ausgegebene Kleber hat eine Temperatur zwischen 23 und 28 °C, der hydrostatische Druck im Dispenserkopf 36 ist so gewählt, daß bei einer relativ kurzen Öffnungszeit (einige ms) Ventilelements 44 die portionsweise Menge 47 an Kleber ausgegeben wird, die für einen Klebepunkt an der betreffenden Stelle ausreicht.

An das Gehäuse 40 des Dispenserkopfes 36 ist noch ein kleiner Druckpuffer 50 angesetzt. Er verhindert, daß während der Ausgabe von Kleber am Auslaß 48 der hydrostatische Druck im Dispenserkopf 36 zusammenbricht. In der gezeigten, einfachen Ausbildung ist der Druckpuffer in eine mit dem Innenraum des Dispenserkopfes 36 verbundenen Ansatz untergebracht. Er besteht aus einer Rollmembran und einer diese vorbelastenden Feder.

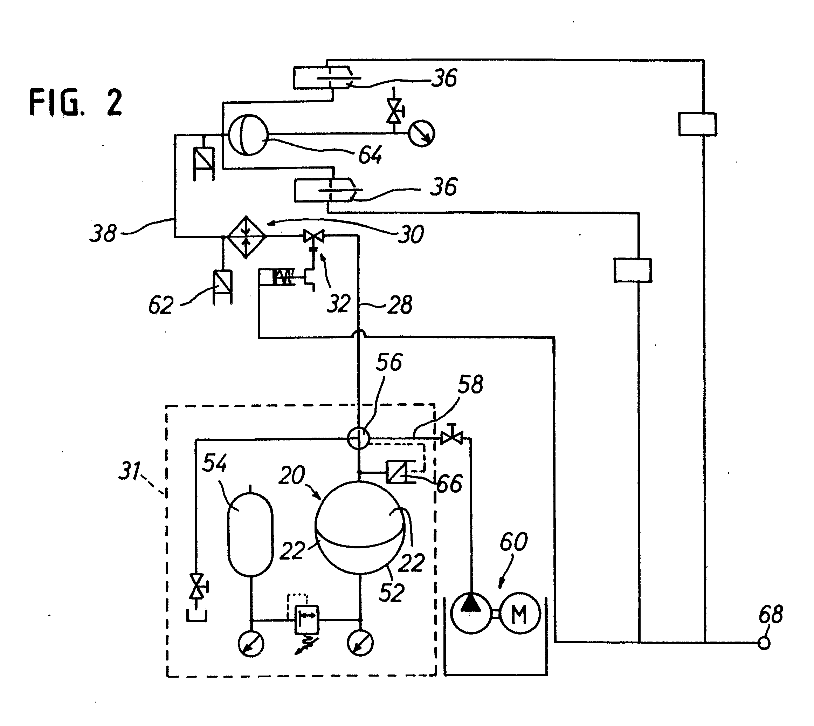

In der erfindungsgemäßen Vorrichtung nach Fig. 2 befindet sich in einem gekühlten Bereich 31 ein Membrangefäß 52, beispielsweise ein Membranspeicher mit Vitonmembrane. Der in der Figur unterhalb der Membrane befindliche Bereich wird mit einem hydraulischen Druckmedium, beispielsweise Öl oder Wasser, beaufschlagt. Hierzu ist in der Zeichnung ein Druckgefäß 54 vorgesehen, das über einen Druckminderer eine hydraulische Belastung der Membrane einzustellen gestattet. Anstelle des Druckgefäßes 54 kann auch eine Pumpe eingesetzt werden.

Auf der in der Figur oberen Seite der Membrane befindet sich im Membrangefäß 52 die pastöse Masse, deshalb ist auch dort die erste Leitung 28 angesetzt. Innerhalb des gekühlten Bereichs 31 ist in diese ein Mehrwegeventil 56 eingeschaltet. Es ist zugleich mit einer Speiseleitung 58 verbunden. Über diese wird pastöse Masse zugeführt um das Membrangefäß 52 zu füllen. Hierzu ist eine separate Einheit 60 aus Motor und Schneckenpumpe vorgesehen, die Schneckenpumpe fördert pastöse Masse 22 in die Speiseleitung 58. Die Einheit 60 ist üblicherweise entfernt, sie wird nur dann angesetzt, wenn das Membrangefäß 52 aufgefüllt werden muß. Andere Möglichkeiten um das Membrangefäß 52 zu füllen sind hierdurch nicht ausgeschlossen.

Durch das Membrangefäß 52 ist sichergestellt, daß die pastöse Masse normalerweise nicht in Kontakt mit mechanischen Pumpen kommt. Beim Betrieb der Pumpe könnten Temperaturen auftreten, die zu einem Aushärten des Klebers führen. Weiterhin läßt sich die Anordnung innerhalb des gekühlten Bereichs 31 besser warten und reinigen als dies bei einem direkten Kontakt zwischen Pumpe und pastöser Masse möglich wäre.

Es sind Vorkehrungen dafür getroffen, daß beim Anschluß der Einheit 60 an die Speiseleitung 58 keine Luft in das System eingeschleust wird.

Die Zwischenstation 30 umfaßt - wie in der Darstellung nach Fig. 1 -eine Druckregeleinrichtung 32 in Form eines proportional arbeitenden Gasdruckregelventils, es wird über Druckluft gesteuert und eine Temperiereinrichtung 34 in Form einer Heizkordel mit einer Heizleistung von ca. 200 Watt. An ihrem Ausgang ist ein Temperatursensor in die zweite Leitung 38 eingeschaltet, er steuert über eine nicht dargestellte, elektronische Steuerkarte die Heizleistung in der Heizkordel.

Die zweite Leitung 38 verzweigt sich in zwei gleichlange Teilstücke, die jeweils einem Dispenserkopf 36 pastöse Masse zuführen. Als Druckpuffer 50 ist am Verzweigungspunkt ein kleines Membrangefäß 64, das ähnlich wie das Membrangefäß 52 ausgeführt ist, vorgesehen. Sein in der Figur links von der Membrane befindlicher Bereich ist mit pastöser Masse gefüllt, der rechte Membrane befindliche Bereich steht unter Druckluft mit etwa 2 bis 2,5 bar. Der entsprechende Druck liegt in der zweiten Leitung 38 vor. Das Membrangefäß 64 in der beschriebenen Anordnung sorgt nicht nur für eine Konstanz des hydrostatischen Drucks der pastösen Masse innerhalb der Leitung 38, sondern hat darüberhinaus noch einen Vorrat an pastöser Masse 22 gespeichert. Bei gefülltem Membrangefäß 64 befinden sich etwa 70 g pastöser Masse in diesem Gefäß. Dadurch kann das große Membrangefäß 52 ausgetauscht oder die Förderung in der ersten Leitung 28 für eine gewisse Zeit unterbrochen werden, ohne daß das Auftragen pastöser Masse auf einer Leiterplatine gestoppt werden muß.

Im gekühlten Bereich 31 ist mit der ersten Leitung 28 ein Drucksensor 66 verbunden, der bei einem abrupten Druckabfall in der ersten Leitung 28 das stromabwärts befindliche Ventil 56 schließt. Hierdurch wird vermieden, daß bei einer Undichtigkeit außerhalb des gekühlten Bereichs 31 der gesamte Inhalt des Membrangefäßes 52 durch die Leckstelle gepreßt wird.

Mit 68 ist ein Druckluftanschluß bezeichnet, über den einerseits die beiden Dispenserköpfe 36 unabhängig voneinander mit Druckluftstößen versorgt werden und andererseits die Druckregeleinrichtung 32 betätigt wird.

## Ansprüche

1. Verfahren zum Aufbringen kleiner Mengen einer pastösen Masse (22), z.B. Kleber oder Lötpaste, auf Leiterplatten, bei dem die pastöse Masse aus einem Vorratsbehälter (20) unter Druck über eine Leitung einem Dispenserkopf (36) zugeführt und von diesem bei Verarbeitungsdruck und -temperatur portionsweise auf eine Leiterplatte ausgegeben wird,
dadurch gekennzeichnet, daß die pastöse Masse bei niedriger, deutlich unter der Verarbeitungstemperatur liegender Temperatur von einem hohen, deutlich über dem Verarbeitungsdruck liegenden, hydraulisch oder mechanisch erzeugten Druck, insbesondere einer Schneckenpumpe (24) aus dem gekühlten, ortsfest angeordneten Vorratsbehälter über eine erste, gekühlte Leitung (28) zu einer Zwischenstation (30) gefördert wird, daß in der Zwischenstation die pastöse Masse einerseits aufgewärmt und dabei so temperiert wird, daß am Dispenserkopf die gewünschte Verarbeitungstemperatur vorliegt und andererseits druckmäßig so entspannt wird, daß am Dispenserkopf der gewünschte Arbeitsdruck herrscht und daß die Zwischenstation über eine zweite Leitung (38) mit dem Dispenserkopf verbunden ist und mindestens eine der beiden Leitungen (28 oder 38) flexibel ausgeführt ist.

2. Verfahren nach Anspruch 1, dadurch gekennzeichnet, daß über einen im Bereich des Dispenserkopfes angeordneten, kleinen Druckpuffer (50) ein Druckabfall des hydrostatischen Drucks der pastösen Masse während jeder Ausgabe einer kleinen Menge abgepuffert wird.

3. Verfahren nach Anspruch 1 oder 2, dadurch gekennzeichnet, daß des Innenvolumen der zweiten Leitung (38) und des Dispenserkopfes (38) möglichst klein gewählt wird, damit die dort enthaltene Menge an pastöser Masse möglichst gering gewählt wird.

4. Verfahren nach einem der Ansprüche 1 bis 3, dadurch gekennzeichnet, daß an einer Zwischenstation (30) mindestens zwei zweite Leitungen (38) anschließbar sind, die gleichlang gewählt und jeweils mit einem Dispenserkopf (36) verbunden sind.

5. Vorrichtung zum Aufbringen kleiner Mengen einer pastösen Masse (22), z. B. Kleber oder Lötpaste, auf Leiterplatten, mit einem Vorratsbehälter (20) für die pastöse Masse und einem mit diesem über eine Leitung, durch die die pastöse Masse unter Druck gefördert wird, verbundenen Dispenserkopf (36),
dadurch gekennzeichnet, daß eine mechanische Pumpe, insbesondere eine Schneckenpumpe (24) vorgesehen ist, die die pastöse Masse aus dem gekühlten, ortsfest angeordneten Vorratsbehälter und mit einem Druck oberhalb 10 bar fördert und die über eine erste, gekühlte Leitung (28) mit einer Zwischenstation (30) verbunden ist, daß die Zwischenstation eine Druckregeleinrichtung (32) und eine Temperiereinrichtung (34) aufweist und über eine zweite Leitung (38) an den Dispenserkopf angeschlossen ist, wobei mindestens eine Leitung (28 oder 38) flexibel ausgebildet ist und daß die Druckregeleinrichtung den Druck der pastösen Masse soweit herabsetzt, daß am Dispenserkopf der Verarbeitungsdruck anliegt und daß die Temperiereinrichtung die Temperatur der Masse soweit erhöht, daß am Dispenserkopf die notwendige Verarbeitungstemperatur der pastösen Masse vorliegt.

6. Vorrichtung nach Anspruch 5, dadurch gekennzeichnet, daß im Bereich des Dispenserkopfes (36) ein Temperatursensor angeordnet ist, der eine Regelelektronik der Temperiereinrichtung (34) steuert und/oder daß im Dispenserkopf ein Druckmeßsensor vorgesehen ist, der die Regelelektronik der Druckregeleinrichtung (32) steuert.

7. Vorrichtung nach Anspruch 5 oder 6, dadurch gekennzeichnet, daß am Gehäuse (40) der Pumpe (24) ein mit Schneiden versehener Anschlußstutzen (25) für einen Vorratsbehälter (20) senkrecht nach oben vorspringt.

8. Vorrichtung nach einem der Ansprüche 5 bis 7, dadurch gekennzeichnet, daß der Dispenserkopf (36) ein Ventilelement (44) aufweist, daß durch eine Feder (42) in Schließstellung vorbelastet ist und pneumatisch oder elektrisch von seinem Sitz abhebbar ist.

9. Vorrichtung nach einem der Ansprüche 5 bis 8, dadurch gekennzeichnet, daß die pastöse Masse (28) in einem Membrangefäß (52) untergebracht ist, das unter hydraulischem Druck steht.

10. Vorrichtung nach einem der Ansprüche 5 bis 9, dadurch gekennzeichnet, daß im gekühlten Bereich (31) ein Drucksensor (66) an die erste Leitung (28) angeschlossen ist, der bei einem abrupten Abfall ein stromabwärts, aber innerhalb des gekühlten Bereichs (31) vorgesehenes Ventil (z. B. 56) schließt.

**FIG. 1**

FIG. 2